# EUROPEAN PATENT APPLICATION

(11) **EP 1 906 467 A2**
(43) Date of publication of application: **02.04.2008**
(21) Application number: 07252152.9
(22) Date of filing: 25.05.2007
(51) Int. Cl.: H01L 51/56, H01L 27/32

(54) **Organic light emitting display and fabricating method thereof and moving device therefor**

(30) Priority: 28.09.2006 KR 20060095134
(71) Applicant: Samsung SDI Co., Ltd., Suwon-si, Gyeonggi-do (KR)
(72) Inventor: Kim, Jongyun, Legal & IP Team, Yongin-si Gyeonggi-do (KR)
(74) Representative: Mounteney, Simon James

(57) **Abstract**

An organic light emitting display includes: a substrate; a buffer layer disposed on a top surface of the substrate; a semiconductor layer disposed on the buffer layer; a gate insulating layer disposed on the semiconductor layer; a gate electrode disposed on the gate insulating layer; an inter-layer dielectric layer disposed on the gate electrode; a source/drain electrode disposed on the inter-layer dielectric layer; an insulating layer disposed on the source/drain electrode; an organic light emitting diode disposed on the insulating layer; and a non-transmissive layer disposed on a bottom surface of the substrate.

## Description

### BACKGROUND

### 1. Field of the Invention

The present invention relates to an organic light emitting display, a fabricating method thereof and a moving device therefor, and, more particularly, to a thin organic light emitting display, a fabricating method thereof and a moving device therefor that can be used in the manufacture of the thin organic light emitting display.

### 2. Description of the Related Art

An organic light emitting display can be a flat panel display device that can self-emit lights through application of an electric current to a fluorescent or phosphorescent organic compound and recombination of electrons and holes. The organic light emitting display can display an image by driving organic light emitting diodes, for example organic light emitting diodes of an n by m matrix, by a voltage or a current.

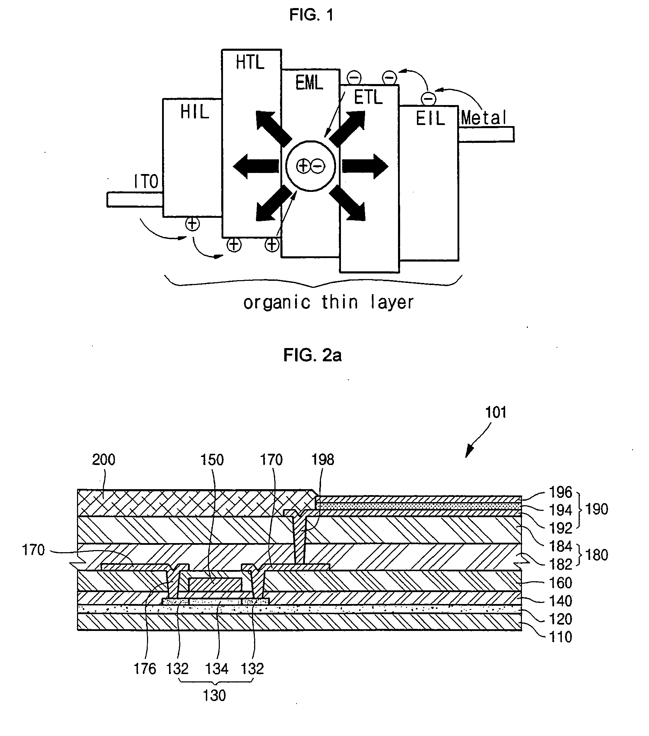

As shown in FIG. 1, an organic light emitting diode has an anode (ITO), an organic thin layer and a cathode electrode (metal). The organic thin layer can include: an emitting layer (EML) that emits light by coupling electrons and holes and forming excitons; an electron transport layer (ETL) that properly controls the moving velocity of the electrons; and a hole transport layer (HTL) that properly controls the moving velocity of the holes. An electron injecting layer (EIL) for improving the electron injection efficiency can be further formed on the electron transport layer, and a hole injecting layer (HIL) for improving the hole injection efficiency can be further formed on the hole transport layer.

The organic light emitting display can be applied to wide varieties of moving image flat panel display devices because of its wide viewing angle, high response speed, ability to self-emit light and so forth. Moreover, the organic light emitting display has low power consumption and can be manufactured to be lightweight and thin because a backlight is not needed. Furthermore, the organic light emitting display can be manufactured at a low temperature and can be manufactured at a low cost because of its simple fabricating process.

In addition, as electronic devices, such as a cellular phone, a Personal Digital Assistant (PDA), a notebook, a computer monitor, a television and so forth, become slimmer, a flat panel display device (e.g., an organic light emitting display) should also be manufactured to be thinner (or slimmer), e.g., having a thickness of below about 1mm. However, in a typical organic light emitting display, it is difficult to manufacture the organic light emitting display having a thickness of below 1mm due to a need to protect and/or encapsulate the element layers of the organic light emitting display (e.g., the semiconductor layer, the organic light emitting diode, etc.).

### SUMMARY OF THE INVENTION

An aspect of the present invention is to provide a thin organic light emitting display, a fabricating method thereof and a moving device therefor.

Another aspect of the present invention is to improve the productivity and reduce the fabricating cost by reducing the fabricating process time.

Another aspect of the present invention is to block (or prevent) a warping phenomenon of a substrate during a fabrication process and to block (or prevent) a damage and breakage phenomenon of the substrate by blocking (or preventing) a physical contact of the center of the substrate.

An organic light emitting display according to a first aspect of the present invention is as set out in Claim 1. Optional features of this aspect are set out in Claims 2 to 15.

According to a second aspect of the present invention there is provided a method of fabricating an organic light emitting display as set out in Claim 16. Optional features of this aspect are as set out in Claims 17 to 25.

According to a third aspect of the present invention there is provided a - moving device for an organic light emitting display as set out in Claim 26. Optional features of this aspect are as set out in Claims 27 to 29.

As such, the organic light emitting display according to embodiments of the present invention can be readily applied to various electronic display devices, such as a cellular phone, a PDA, a notebook, a computer monitor and a television that are thin (or slim), by forming the organic light emitting display on a substrate having a thickness of from 0.05mm to 1mm.

Moreover, in embodiments of the invention, the organic light emitting display can block (or prevent) a UV-ray from affecting a semiconductor layer and/or an organic light emitting diode through the substrate during use by forming a non-transmissive layer on the substrate.

The fabricating method of an organic light emitting display according to embodiments of the invention can reduce an entire processing time by about 50% by bonding two substrates having (or each having) the thickness of from 0.05mm to 1mm and performing simultaneously (or concurrently) a semiconductor forming process and an organic thin layer forming process (in one embodiment, each process includes a cleaning operation, an etching operation, a light exposure operation, a development operation, a heat treatment operation and so on).

Moreover, the fabricating method can block (or prevent) a UV-ray due to a light exposure operation during a fabricating process from affecting another opposing organic light emitting display by forming the non-transmissive layer on the bottom surface of the substrate.

Furthermore, the fabricating method can block (or prevent) the organic light emitting display from warping or being damaged due to gravity by the repulsive force between the magnetic layer and the moving device moving the magnetic layer during a fabricating process by forming the non-transmissive layer and the magnetic layer on the bottom surface of the substrate.

In addition, the fabricating method can block (or prevent) the substrates or the metals formed on the surfaces of the substrates from contacting with each other when bonding the two substrates and thus can block (or prevent) the damage of the substrate by forming the non-transmissive layer, the magnetic layer and the anti-friction layer or the non-transmissive layer and the anti-friction layer on the bottom surface of the substrate.

The moving device of the organic light emitting display according to embodiments of the invention can block or prevent the substrate from warping or being damaged, by supporting the edge portion of the substrate on which a semiconductor layer and/or an organic light emitting diode are not formed by an anti-slide pad having a relatively high elasticity, and by supporting the central region of the substrate on which the semiconductor layer and/or the organic light emitting diode are formed by a shock-absorbing member in a non-contact manner.

Moreover, the moving device can block or prevent the central region of the substrate, which is not supported by the anti-slide pad, from contacting with the shock-absorbing member and can maintain the flat state of the central region of the substrate during transfer or process, by mounting the magnet on the shock-absorbing member so as to repulse the magnetic layer formed on the two bonded substrates.

### BRIEF DESCRIPTION OF THE DRAWINGS

The accompanying drawings, together with the specification, illustrate exemplary embodiments of the present invention, and, together with the description, serve to explain the principles of the present invention.

FIG. 1 is a schematic view showing an organic light emitting diode.

FIGs. 2a, 2b, 2c, 2d, and 2e are sectional schematic views showing organic light emitting displays according to embodiments of the present invention.

FIGs. 3a, 3b, 3c, 3d, and 3e are sectional schematic views showing organic light emitting displays according to embodiments of the present invention with an encapsulation operation completed.

FIG. 4 is a flow chart showing a fabricating method of an organic light emitting display according to an embodiment of the present invention.

FIGs. 5a, 5b, 5c, 5d, 5e, 5f, 5g, 5h, and 5i are sectional schematic views showing a fabricating sequence of an organic light emitting display according to an embodiment of the present invention.

FIGs. 6a and 6b are top schematic views showing a moving device of an organic light emitting display according to an embodiment of the present invention, and FIG. 6c is a sectional view taken along a line A-A of FIG. 6b.

FIG. 7 is an enlarged partial sectional schematic view showing a state in which a bonded substrate is supported by a shock absorber in a moving device.

FIG. 8 is a sectional schematic view showing a part of an organic light emitting display according to an embodiment of the present invention.

### DETAILED DESCRIPTION

In the following detailed description, only certain exemplary embodiments of the present invention are shown and described, by way of illustration. As those skilled in the art would recognize, the invention may be embodied in many different forms and should not be construed as being limited to the embodiments set forth herein. Also, in the context of the present application, when an element is referred to as being "on" another element, it can be directly on the another element or be indirectly on the another element with one or more intervening elements interposed therebetween. Like reference numerals designate like elements throughout the specification.

FIGs. 2a to 2e are sectional schematic views showing organic light emitting displays 101, 102 103, 104 and 105 according to embodiments of the present invention.

As shown in FIG. 2a, the organic light emitting display 101 includes: a substrate 110; a buffer layer 120 formed on the substrate 110; a semiconductor layer 130 formed on the buffer layer 120; a gate insulating layer 140 formed on the semiconductor layer 130; a gate electrode 150 formed on the gate insulating layer 140; an inter-layer dielectric layer 160 formed on the gate electrode 150; a source/drain electrode 170 formed on the inter-layer dielectric layer 160; an insulating layer 180 formed on the source/drain electrode 170; an organic light emitting diode 190 formed on the insulating layer 180; and a pixel defining layer 200 formed on the insulating layer 180 at the outer circumference of the organic light emitting diode 190.

The top and bottom surfaces of the substrate 110 are substantially flat, and the thickness between the top surface and the bottom (under) surface can be from about 0.05mm to about 1mm. In one embodiment, if the thickness of the substrate 110 is below about 0.05mm, the substrate 110 may be damaged due to cleaning, etching and heat treatment processes and has a low strength against an external force. In another embodiment, if the thickness of the substrate 110 is above about 1mm, it is difficult to apply the substrate to various display devices that are to be thin (or slim). Furthermore, the substrate 110 can be formed of any material selected from glass, plastic, polymer, steel and their equivalents, but not limited thereto.

The buffer layer 120 is formed on the top surface of the substrate 110. The buffer layer 120 is for reducing (or preventing) moisture (H₂O), hydrogen (H₂) or oxygen (O₂), etc. from penetrating through the substrate 110 and infiltrating into the semiconductor layer 130 or the organic light emitting diode 190. For this purpose, the buffer layer 120 can be formed of any layer selected from an oxide layer (SiO₂) a nitride layer (Si₃N₄) and their equivalents that can be easily formed during a semiconductor process, but not limited thereto. In one embodiment, the buffer layer 120 can be omitted.

The semiconductor layer 130 is formed on the top surface of the buffer layer 120. The semiconductor layer 130 includes source/drain sections 132 formed at two opposite sides of the semiconductor layer 130 and a channel section 134 formed between the source/drain sections 132. In one embodiment, the semiconductor layer 130 may be part of a thin film transistor. The thin film transistor can be formed of any transistor selected from an amorphous silicone thin film transistor, a poly-silicone thin film transistor, an organic thin film transistor, a micro silicone thin film transistor and their equivalents, but not limited thereto. Moreover, in case of the poly-silicone thin film transistor, the poly-silicone thin film transistor can be crystallized by a crystallizing method using a laser at a low temperature, a crystallizing method using a metal, a crystallizing method using a high pressure and their equivalents, but not limited thereto. The crystallizing method using a laser may include an Excimer Laser Annealing (ELA) method, a Sequential Lateral Solidification (SLS) method, a Thin Beam Direction Crystallization (TDX) method, etc., but not limited thereto. Moreover, the crystallizing method using a metal may include a Solid Phase Crystallization (SLS) method, a Metal Induced Crystallization (MIC) method, a Metal Induced Lateral Crystallization (MILC) method, and a Super Grained Silicone (SGS) method, but not limited thereto. In one embodiment, the thin film transistor may be any MOS selected from a PMOS, an NMOS and their equivalents, but not limited thereto.

The gate insulating layer 140 is formed on the top surface of the semiconductor layer 130 but with a gap provided over each of the two source/drain sections 132. In the embodiments illustrated, the gate insulating layer 140 is also formed on the buffer layer 120 at the outer periphery of the semiconductor layer 130. Moreover, the gate insulating layer 140 can be formed of any layer selected from an oxide layer, a nitride layer and their equivalents that can be easily formed during a semiconductor process, but not limited thereto.

The gate electrode 150 is formed on the top surface of the gate insulating layer 140 that is provided on the semiconductor layer 130. More specifically, the gate electrode 150 is formed on the gate insulating layer 140 to correspond to the channel section 134 of the semiconductor layer 130. The gate electrode 150 enables a hole or electron channel to be formed in the channel section 134 by applying an electric field to the channel section 134 in the lower part of the gate insulating layer 140. Moreover, the gate electrode 150 can be formed of any material selected from metal (e.g., MoW, Ti, Cu, AINd, Al, Cr, Mo alloy, Cu alloy, Al alloy, etc.), doped poly silicone and their equivalents, but not limited thereto.

The inter-layer dielectric layer 160 is formed on the top surface of the gate electrode 150and on the gate insulating layer 140 at the outer periphery of the gate electrode 150. Moreover, the inter-layer dielectric layer 160 can be formed of any material selected from a polymer-based insulating material, a plastic-based insulating material, a glass-based insulating material and their equivalents, but not limited thereto.

Two source/drain electrodes 170 are formed on the top surface of the inter-layer dielectric layer 160. Each has an electrically conductive contact 176 penetrating through the inter-layer dielectric layer 160 , which connects the semiconductor layer 130 and the source/drain electrode 170. That is, the source/drain sections 132 of the semiconductor layer 130 are electrically coupled with the source/drain electrodes 170 via (or by) the electrically conductive contacts 176. Moreover, the source/drain electrodes 170 can be formed of a metal material that is substantially the same as that of the gate electrode 150, but not limited thereto. Also, the semiconductor layer 130 (i.e., thin film transistor) can have an ordinary coplanar structure. However, the semiconductor layer 130 described in the present invention is not limited to the coplanar structure. The semiconductor layer can have any suitable structure for a thin film transistor, for example, any structure selected from an inverted coplanar structure, a staggered structure, an inverted staggered structure and their equivalents, but not limited thereto.

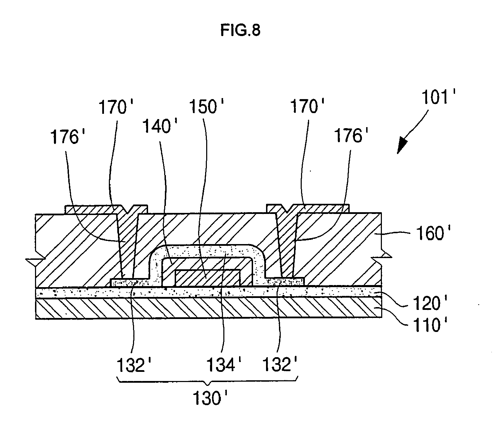

As an example, an inverted coplanar structure according to an embodiment of the present invention is shown in FIG. 8. In FIG. 8, an organic light emitting display 101' includes: a substrate 110'; a buffer layer 120' formed on the substrate 110'; a gate electrode 150' formed on the buffer layer 120'; a gate insulating layer 140' formed on the gate electrode 150'; a semiconductor layer 130' formed on the gate insulating layer 140'; an inter-layer dielectric layer 160' formed on the semiconductor layer 130'; and a source/drain electrode 170' formed on the inter-layer dielectric layer 160'; an insulating layer (e.g., layer 180) may be formed on the source/drain electrode 170'; an organic light emitting diode (e.g., diode 190) may be formed on the insulating layer; and a pixel defining layer (e.g., layer 200) may be formed on the insulating layer at the outer circumference of the organic light emitting diode. The semiconductor layer 130' includes source/drain sections 132' formed at two opposite sides of the semiconductor layer 130' and a channel section 134' formed between the source/drain sections 132'. In one embodiment, the semiconductor layer 130' may be part of a thin film transistor. In this embodiment, an electrically conductive contact 176' penetrates through the inter-layer dielectric layer 160' to form a connection between the semiconductor layer 130' and the source/drain electrode 170'. That is, the semiconductor layer 130' is electrically coupled with the source/drain electrode 170' via (or by) the electrically conductive contact 176'.

Referring back to FIG. 2a, the insulating layer 180 is formed on the top surface of the source/drain electrodes 170 and the surrounding portions of the inter-layer dielectric layer 160. In this particular embodiment, the insulating layer 180 includes a protective layer 182 and a planarization layer 184 formed on the top surface of the protective layer 182. The protective layer 182 is for covering the source/drain electrodes 170 and the inter-layer dielectric layer 160 and for protecting the source/drain electrodes 170 and the gate electrode 150, etc. The protective layer 182 can be formed of any layer selected from an inorganic layer and its equivalent, but not limited thereto. The planarization layer 184 covers the protective layer 182. The planarization layer 184 is for flattening the entire (or substantially the entire) surface of the protective layer 182 (or the device above and/or below the planarization layer 184) and can be formed of any material selected from Benzo Cyclo Butene (BCB), acryl and their equivalents, but not limited thereto.

The organic light emitting diode 190 is formed on the top surface of the insulating layer 180. The organic light emitting diode 190 includes an anode 192, an organic light emitting thin layer 194 formed on the top surface of the anode 192 and a cathode 196 formed on the top surface of the organic light emitting thin layer 194. The anode 192 can be formed of any material selected from Indium Tin Oxide (ITO), ITO/Ag, ITO/Ag/ITO and their equivalents, but not limited thereto. The ITO is a transparent conductive material (or layer) in which a work function is uniform and a hole injecting barrier to the organic light emitting thin layer 194 is small, and the Ag is a layer that reflects the light emitted from the organic light emitting thin layer 194 to the top surface of the display 101 in a top emission system. In addition, the organic light emitting thin layer 194 can include an emitting layer (EML) that emits the light by joining the electrons with the holes and forming excitons, an electron transport layer (ETL) that adequately adjusts the moving velocity of the electrons, and a hole transport layer (HTL) that adequately adjusts the moving velocity of the holes. Moreover, an electron injecting layer (EIL) for improving the injection efficiency of the electron can be formed on the electron transport layer, and a hole injecting layer (HIL) for improving the injection efficiency of the hole can be further formed on the hole transport layer. Furthermore, the cathode 196 can be formed of any material selected from Al, MgAg alloy, MgCa alloy and their equivalents, but not limited thereto. If a top emission system is employed and the cathode is formed of Al, then the thickness of the cathode (or the Al cathode) should be sufficiently thin. However, in this case, the resistance of the Al cathode may be relatively high, and thus the electron injecting barrier may become relatively large. The MgAg alloy has an electron injecting barrier that is smaller than that of the Al, and the MgCa alloy has an electron injecting barrier that is smaller than that of the MgAg Alloy. However, the MgAg alloy and the MgCa alloy should be completely protected (encapsulated or blocked) from the outside because they are sensitive to the surrounding environment and can oxidize and form an insulating layer. Moreover, the anode 192 of the organic light emitting diode 190 and the source/drain electrode 170 can be electrically coupled by an electrically conductive contact 198 penetrating through the insulating layer 180 (the protective layer 182 and the planarization layer 184). In addition, although the embodiment of FIG. 2a has been described based on a top emission system in which the light is emitted in the direction from the lower part to the upper part of the substrate 110, the present invention can be applied to a bottom emission system in which the light is emitted in the direction from the upper part to the lower part of the substrate 110 or a dual emission system in which the light is simultaneously emitted in the directions from the lower part to the upper part and from the upper part to the lower part of the substrate 110.

The pixel defining layer 200 is formed on the top surface of the insulating layer 180 at the outer circumference of the organic light emitting diode 190. The pixel defining layer 200 defines boundaries between a red organic light emitting diode, a green organic light emitting diode and a blue organic light emitting diode, and thus defines light emitting boundary regions between pixels. Moreover, the pixel defining layer 200 can be formed of any material selected from polyimide and its equivalent, but not limited thereto.

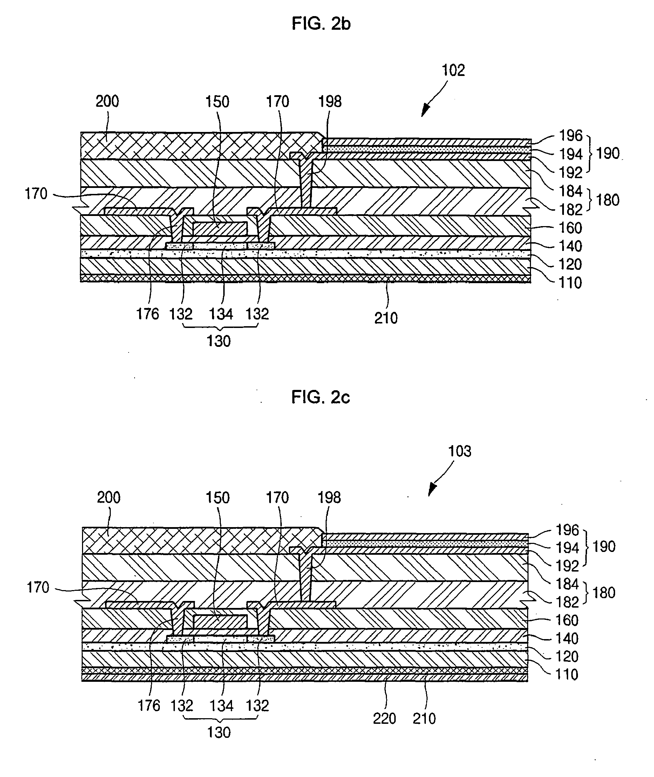

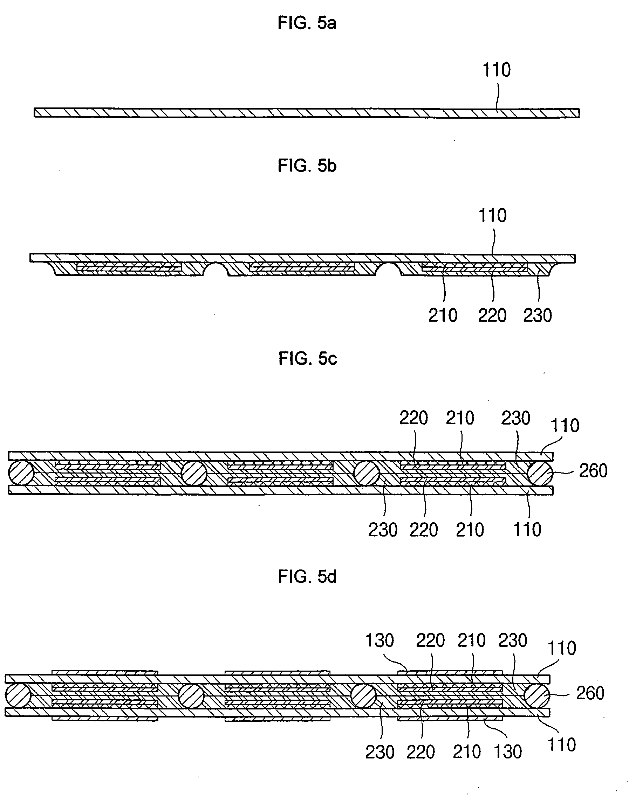

Next, as shown in FIG. 2b, the organic light emitting display 102 is substantially the same as the organic light emitting display 101, but is further provided on the bottom surface of the substrate 110 with a non-transmissive layer 210. The non-transmissive layer 210 is for blocking (or preventing) a UV-ray (ultraviolet ray) from transmitting (or substantially transmitting) to an another substrate 110 opposing the substrate 110 provided with the non-transmissive layer 210 when forming the semiconductor layer 130 and the organic light emitting diode 190 and so on by bonding two of the substrates 110 (as described in more detail below, e.g., as shown in FIG. 5c). In one embodiment, the non-transmissive layer 210 is also for blocking (or preventing) external UV-rays from transmitting (or substantially transmitting) to the semiconductor layer 130 and/or the organic light emitting diode 190 after the two substrates 110 are separated from each other. That is, in one embodiment, the non-transmissive layer 210 is for shielding the other substrate 110 from the UV-ray (ultraviolet ray) and/or for shielding the semiconductor layer 130 and/or the organic light emitting diode 190 from the external UV-ray. The non-transmissive layer 210 can be substantially formed of any suitable material having a UV-ray protective agent and its equivalent. Moreover, the non-transmissive layer 210 can be formed of any material having a metal that does not transmit the UV-ray, a transparent UV-ray protective agent, an opaque UV-ray protective agent and/or their equivalents. Furthermore, if the non-transmissive layer 210 is a metal, it can be formed of any material selected from chrome (Cr), chrome oxide (Cr₂O₃), aluminum (Al), gold (Au), silver (Ag), magnesium oxide (MgO), silver alloy and their equivalents, but not limited thereto. In one embodiment, the thickness of the non-transmissive layer 210 is from 0.05 µm and 0.3 µm (500Å to 3000Å). In one embodiment, if the thickness of the non-transmissive layer 210 is below 0.05 µm (500Å), then the UV-ray protection factor is low, thereby affecting the semiconductor layer 130 or the organic light emitting diode 190 during or after a fabricating process.
In another embodiment, if the thickness of the non-transmissive layer 210 is above 0.3 µm (3000Å), then the non-transmissive layer excessively thickens without adding to any advantageous increase to the UV-ray protection factor.

Furthermore, as shown in FIG. 2c, the organic light emitting display 103 is substantially the same as the organic light emitting display 102, but is further provided on the bottom surface of the non-transmissive layer 210 with a magnetic layer 220. The magnetic layer 220 is for blocking (or preventing) the substrate 110 from warping when forming the semiconductor layer 130 and the organic light emitting diode 190 and so on when using two bonded substrates 110 (as described in more detail below). That is, the substrate 110 is blocked from being warped (or from having a warpage) by positioning a magnet, which has the same polarity to the magnetic layer 220 to repulse the polarity of the magnetic layer 220, on the bottom surface of the substrate 110. The magnetic layer 220 can be formed of at least one magnet selected from an AlNiCo magnet, a ferrite magnet, a rare-earth magnet, a rubber magnet, a plastic magnet and their equivalents, but not limited thereto. That is, according to one embodiment of the present invention, an electromagnet that is not a permanent magnet can be formed on the bottom surface of the non-transmissive layer 210 or a pattern of an electromagnet can be formed thereon, and thus they can be substituted for the magnetic layer. In one embodiment, the thickness of the magnetic layer 220 is from 10µm to 100µm. In one embodiment, if the thickness of the magnetic layer 220 is below 10µm, then it is difficult to obtain a magnetic force that is sufficient for blocking (or preventing) the warping (or warpaging) of the substrate 110 during a fabricating process. In another embodiment, if the thickness of the magnetic layer 220 is above 100µm, then the magnetic layer excessively thickens the display.

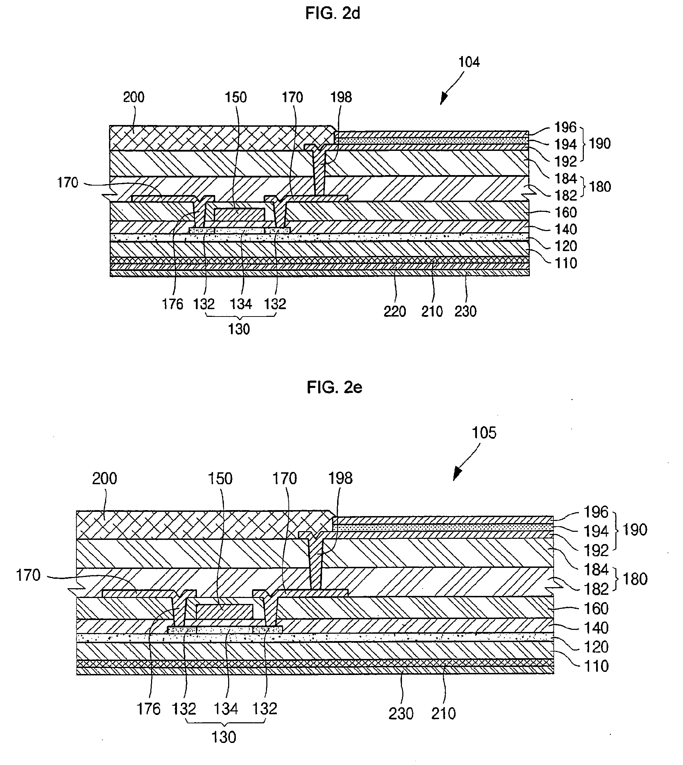

Furthermore, as shown in FIG. 2d, the organic light emitting display 104 is substantially the same as the organic light emitting display 103, but is further provided on the bottom surface of the magnetic layer 220 with an anti-friction layer 230. The anti-friction layer 230 is for blocking (or preventing) two substrates 110 from contacting with each other when forming the semiconductor layer 130 and the organic light emitting diode 190 and so on by the method of bonding two substrates 110 (as described in more detail below). That is, the non-transmissive layer 210 or the magnetic layer 220 formed on the two substrates 110 are not allowed to contact with each other, thereby blocking (or preventing) damage to the substrates 110. The anti-friction layer 230 can be formed of any material selected from an organic material, an inorganic material and their equivalents, but not limited thereto. Moreover, in one embodiment, the thickness of the anti-friction layer 230 is from 10µm to 100µm. In one embodiment, if the thickness of the anti-friction layer 230 is below 10µm, then the non-transmissive layer 210 or the magnetic layer 220 of the substrate 110 can contact with that of the other substrate 110. In another embodiment, if the thickness of the anti-friction layer 230 is above 100µm, the total thickness of the substrate 110 becomes excessively large.

Furthermore, as shown in FIG. 2e, the organic light emitting display 105 is substantially the same as the organic light emitting display 102, but is provided on the bottom surface of the non-transmissive layer 210 with an anti-friction layer 230 (i.e. without a magnetic layer 220). Since the materials and thicknesses of the non-transmissive layer 210 and the anti-friction layer 230 have been described as above, the explanations about them will not be provided again. Here, if the area of the substrate 110 is small and thus there is nearly no probability that the substrate 110 can warp (or warpage), then it is possible for the magnetic layer 220 not to be provided between the non-transmissive layer 210 and the anti-friction layer 230. In one embodiment, the magnetic layer 220 can be omitted in all organic light emitting displays. That is, if the non-transmissive layer 210 and the anti-friction layer 230 are formed relatively thick in a permissible range, then the rigidity of the bonded substrate 110 is raised, and thus the substrate may not be warped during various fabricating processes.

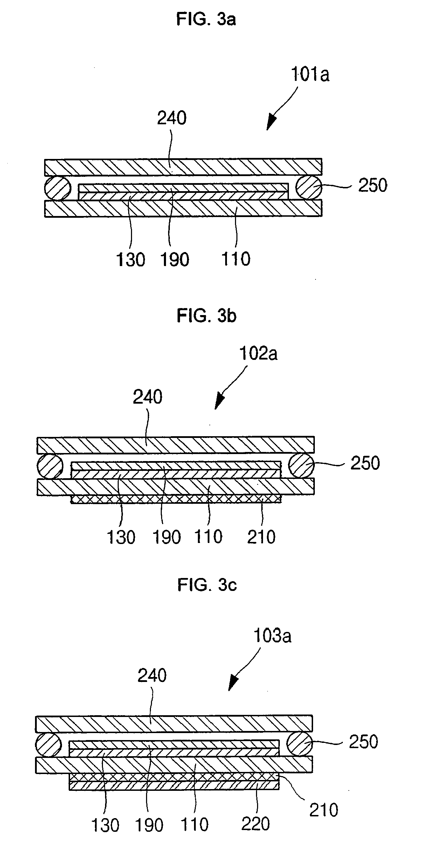

FIGs. 3a to 3e are views showing organic light emitting displays with encapsulation substrates respectively attached thereto according to embodiments of the present invention.

As shown in FIG. 3a, an organic light emitting display 101a according to an embodiment of the present invention can be formed by forming the semiconductor layer 130, the organic light emitting diode 190 and so forth on the surface of the substrate 110 and then attaching an encapsulation substrate 240 thereto. In this embodiment, an encapsulant 250 is interposed between the substrate 110 and the encapsulation substrate 240. The encapsulation substrate 240 can be formed of any material selected from glass, plastic, polymer and their equivalents, but not limited thereto. Moreover, the encapsulant 250 may be at least one adhesive selected from an epoxy adhesive, a UV-ray setting adhesive, a frit and their equivalents, but not limited thereto. If a frit is used as the encapsulant 250, then it is necessary to heat the frit to a given temperature (which may be predetermined), and thus an encapsulation operation can be performed using a laser beam (e.g., to provide the heat). That is, when the frit is positioned between the substrate 110 and the encapsulation substrate 240 and then is irradiated by a laser beam at one side, the frit is melted, and thus the substrate 110 is strongly attached to the encapsulation substrate 240.

Also, as shown in FIG. 3b, an organic light emitting display 102a according to an embodiment of the present invention can be further provided on the bottom surface of the substrate 110 with the non-transmissive layer 210.

Moreover, as shown in FIG. 3c, an organic light emitting display 103a according to an embodiment of the present invention can be sequentially provided on the bottom surface of the substrate 110 with a non-transmissive layer 210 and a magnetic layer 220.

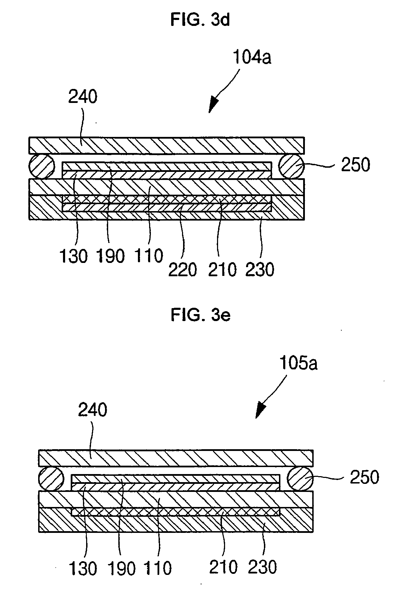

Furthermore, as shown in FIG. 3d, an organic light emitting display 104a according to an embodiment of the present invention can be sequentially provided on the bottom surface of the substrate 110 with a non-transmissive layer 210, a magnetic layer 220 and an anti-friction layer 230.

In addition, as shown in FIG. 3e, an organic light emitting display 105a according to an embodiment of the present invention can be sequentially provided on the bottom surface of the substrate 110 with a non-transmissive layer 210 and an anti-friction layer 230.

Since the non-transmissive layer 210, the magnetic layer 220 and the anti-friction layer 230 formed on the bottom surface of the substrate 110 have been described as above, the explanation about them will not be provided again.

Moreover, the bottom surface of the encapsulation substrate 240 can be further provided with a transparent moisture absorption layer. That is, since the organic light emitting diode 190 is vulnerable to moisture, the transparent moisture absorption layer, which does not block the transmission of the light and can absorb moisture, can be formed on the bottom surface of the encapsulation substrate 240. In one embodiment, the transparent moisture absorption layer can become (or grow) thicker (e.g., as it absorbs moisture) as long as the transparency of the encapsulation substrate 240 is ensured, and, in one embodiment, the thickness of the transparent moisture absorption layer is from 0.1µm to 300µm. In one embodiment, if the thickness of the transparent moisture absorption layer is below 0.1µm, then the transparent moisture absorption layer does not have a sufficient moisture absorption characteristic. In another embodiment, if the thickness of the transparent moisture absorption layer is above 300µm, then the transparent moisture absorption layer can be in danger of contacting the organic light emitting diode 190. Moreover, the transparent moisture absorption layer can be formed of at least one material selected from, but not limited thereto, an alkali metal oxide, an alkaline-earth metal oxide, a metal halide, a metal sulfate and a metal perchlorate, a phosphorus pentoxide (P₂O₅) and their equivalents, and, in one embodiment, the average particle diameter of which is below 100 nm and, in one embodiment, is from 20nm to 100nm.

Moreover, according to one embodiment of the present invention, it is possible to absorb moisture by filling a space between the substrate 110 and the encapsulation substrate 240 with at least one material selected from a layered inorganic substance, a polymer, a hardening agent and their equivalents instead of forming the transparent moisture absorption layer on the encapsulation substrate 240. In one embodiment, after filling the space with the material, a heat treatment process is performed to harden the material.

Furthermore, according to one embodiment of the present invention, a polarizer film can be attached to the surface of each encapsulation substrate 240 to block (or prevent) light reflection phenomenon due to an external light.

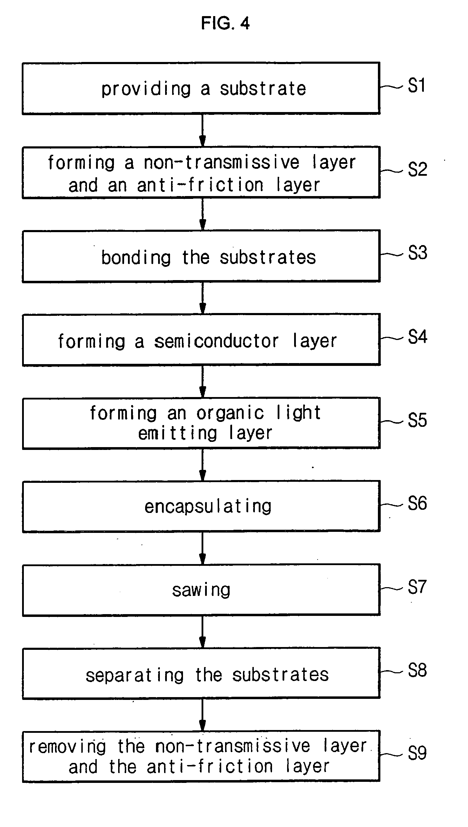

FIG. 4 is a flow chart showing a fabricating method of an organic light emitting display according to an embodiment of the present invention.

As shown in FIG. 4, the fabricating method includes: a step of providing a substrate S1; a step of forming a non-transmissive layer S2; a step of bonding the substrates (e.g., bonding a first substrate 110 with a second or another substrate 110) S3; a step of forming a semiconductor layer S4; a step of forming an organic light emitting diode S5; a step of attaching an encapsulation substrate S6; a step of cutting (or sawing) S7; a step of separating the substrates S8; and a step of removing the non-transmissive layer (and/or the anti-friction layer) S9.

FIGs. 5a to 5i are views showing a fabricating sequence of an organic light emitting display according to an embodiment of the present invention. Hereinafter, a fabricating method of an organic light emitting display according to an embodiment of the present invention will be sequentially described.

As shown in FIG. 5a, in the step of preparing the substrate S1, the substrate 110 is provided, which has substantially flat top and bottom surfaces and a given thickness (which may be predetermined).

In one embodiment, the thickness of the substrate 110 is from about 0.05mm to about 1mm. In one embodiment, if the thickness of the substrate 110 is below about 0.05mm, the substrate 110 may be damaged due to cleaning, etching and heat treatment processes during a fabricating process and has a low strength against an external force and it is difficult to handle the substrate. In another embodiment, if the thickness of the substrate 110 is above about 1mm, it is difficult to apply the substrate 110 to various display devices that are to be thin (or slim). Furthermore, the substrate 110 can be formed of any material selected from ordinary glass, plastic, polymer, steel and their equivalents, but not limited thereto.

As shown in FIG. 5b, in the step of forming the non-transmissive layer S2, the non-transmissive layer 210 having a given thickness (which may be predetermined) is formed on the bottom surface of the substrate 110.

The non-transmissive layer 210 is for blocking (or preventing) a UV-ray (ultraviolet ray) from transmitting (or substantially transmitting) to another substrate 110 opposing the substrate 110 provided with the non-transmissive layer 210 when forming the semiconductor layer and the organic light emitting diode and so on by the method of bonding two substrates 110. In one embodiment, the non-transmissive layer 210 is also for blocking (or preventing) an external UV-ray from transmitting (or substantially transmitting) to the semiconductor layer and/or the organic light emitting diode after the two substrates 110 are separated from each other. The non-transmissive layer 210 can be substantially formed by coating at least one material having a UV-ray protective agent and its equivalent on the surface of the substrate 110. Moreover, the non-transmissive layer 210 can be formed by depositing or coating at least one material having a metal that does not transmit the UV-ray, a transparent UV-ray protective agent, an opaque UV-ray protective agent and/or their equivalents on the surface of the substrate 110. Furthermore, if the non-transmissive layer 210 is a metal, it can be formed by depositing or coating at least one material selected from chrome (Cr), chrome oxide (Cr₂O₃), aluminum (Al), gold (Au), silver (Ag), magnesium oxide (MgO), silver alloy and their equivalents on the surface of the substrate 110. In one embodiment, the thickness of the non-transmissive layer 210 is from 0.05 µm and 0.3 µm (500Å to 3000Å). In one embodiment, if the thickness of the non-transmissive layer 210 is below 0.05 µm (500Å), then the UV-ray protection factor is low, thereby affecting the semiconductor layer or the organic light emitting diode during or after a fabricating process. In another embodiment, if the thickness of the non-transmissive layer 210 is above 0.3 µm (3000Å), then the non-transmissive layer excessively thickens without adding any advantageous increase to the UV-ray protection factor (i.e., the UV-ray protection factor is sufficient below 0.3 µm (3000Å)).

Furthermore, in the step of forming the non-transmissive layer S2, a magnetic layer 220 can be formed on the bottom surface of the non-transmissive layer 210, or a magnetic layer 220 and an anti-friction layer 230 can be sequentially formed on the bottom surface of the non-transmissive layer 210, or an anti-friction layer 230 can be formed on the bottom surface of the non-transmissive layer 210.

Here, the magnetic layer 220 is for blocking (or preventing) the substrate 110 from warping (warpaging) when forming the semiconductor layer 130 and the organic light emitting diode 190 and so on when using the method of bonding two substrates 110. That is, the substrate 110 is blocked from being warped (or from having a warpage) by positioning a magnet, which has the same polarity to the magnetic layer 220 to repulse the polarity of the magnetic layer 220, on the bottom surface of the substrate 110 during a fabricating process. The magnetic layer 220 can be formed of at least one magnet selected from an AlNiCo magnet, a ferrite magnet, a rare-earth magnet, a rubber magnet, a plastic magnet and their equivalents, but not limited thereto. In one embodiment, an electromagnet is used as the magnetic layer 220. In one embodiment, the thickness of the magnetic layer 220 is from 10µm to 100µm. In one embodiment, if the thickness of the magnetic layer 220 is below 10µm, then it is difficult to obtain a magnetic force that is sufficient for blocking (or preventing) the warping of the substrate 110 during a fabricating process. In another embodiment, if the thickness of the magnetic layer 220 is above 100µm, then the magnetic layer excessively thickens. Furthermore, the anti-friction layer 230 is for blocking (or preventing) two substrates 110 from contacting with each other when forming the semiconductor layer and the organic light emitting diode and so on by the method of bonding the two substrates 110. That is, the non-transmissive layers 210 or the magnetic layers 220 formed on the two substrates 110 are not allowed to contact with each other, thereby reducing (or preventing) damage of the substrates 110. The anti-friction layer 230 can be formed of at least one material selected from an organic material, an inorganic material and their equivalents, but not limited thereto. Moreover, in one embodiment, the thickness of the anti-friction layer 230 is from 10µm to 100µm. In one embodiment, if the thickness of the anti-friction layer 230 is below 10µm, then the non-transmissive layer 210 or the magnetic layer 220 of the substrate 110 can contact with that of the other substrate 110. In another embodiment, if the thickness of the anti-friction layer 230 is above 100µm, the total thickness of the substrate 110 becomes excessively large.

As shown in FIG. 5c, in the step of bonding the substrates S3, two identical (or substantially identical) substrates 110, on which the non-transmissive layer 210, the non-transmissive layer 210 and the magnetic layer 220, the non-transmissive layer 210, the magnetic layer 220 and the anti-friction layer 230, or the non-transmissive layer 210 and the anti-friction layer 230 are formed, are provided and bonded to each other. Here, FIG. 5c shows that the non-transmissive layer 210, the magnetic layer 220 and the anti-friction layer 230 are sequentially formed on each of the substrates 110.

Also, a bonding agent 260 is interposed between the two substrates 110 so that the substrates 110 cannot be separated from each other during a bonding process. The bonding agent 260 can be formed by at least one adhesive selected from an ordinary epoxy adhesive, a UV-ray setting adhesive and their equivalents, but not limited thereto. Moreover, the bonding agent 260 can be formed only on the edge portion (or periphery) of one or more of the substrates 110, or the bonding agent can be formed on inner portions of each of the two substrates 110 in the form of a plurality of lines so as to bond the substrates 110 to each other more stably. FIG. 5c shows that a plurality of bonding agents (e.g., four bonding agents) 260 are formed between the two substrates 110.

Furthermore, the anti-friction layer 230 can be formed not in the step S2 of forming the non-transmissive layer 110 but in the step S3 of bonding the substrates 110. That is, if the two substrates 110 are bonded to each other by interposing the bonding agent 260 between them and then a liquid anti-friction layer 230 is injected between the two substrates 210, the liquid anti-friction layer permeates into the gap formed between two substrates 110 by a capillary phenomenon. In one embodiment, after forming the liquid anti-friction layer 230, the liquid anti-friction layer 230 is cured by heat-treating the substrates 110 at a temperature, which may be predetermined. Moreover, in one embodiment, in the step S3 of bonding the substrates 110, anti-friction layers 230 formed on the two substrates 110 are bonded to each other. That is, in one embodiment, the anti-friction layers 230 formed on the two substrates 110 are closely contacted with each other so as to block (or prevent) the substrates 110 from warping or rubbing with each other during a movement of the bonded substrates 110.

As shown in FIG. 5d, in the step S4 of forming the semiconductor layer, semiconductor layers 130 are formed on outer surfaces of the two substrates 110 when they are bonded to each other. That is, the semiconductor layers 130 for driving the organic light emitting display are respectively formed on the surfaces of the two substrates 110 that are opposite to the surfaces on which the anti-friction layers 230 are formed. In one embodiment, a buffer layer can be formed on the surface of the substrate 110 before forming the semiconductor layer 130. Moreover, after forming the semiconductor layer 130, a gate insulating layer, a gate electrode, an inter-layer dielectric layer, a source/drain electrode, an insulating layer and so forth are formed. Since such a constitution has been described as above, the explanation thereabout will not be provided again.

The semiconductor layers 130 can be respectively formed on one substrate 110 and then on the other substrate 110. That is, one semiconductor layer 130 can be formed on one substrate 110 and then another semiconductor layer 130 can be formed on the other substrate 110 (or vise versa). Furthermore, the semiconductor layers 130 can be simultaneously (or concurrently) formed on the two substrates 110 if a process equipment permits.

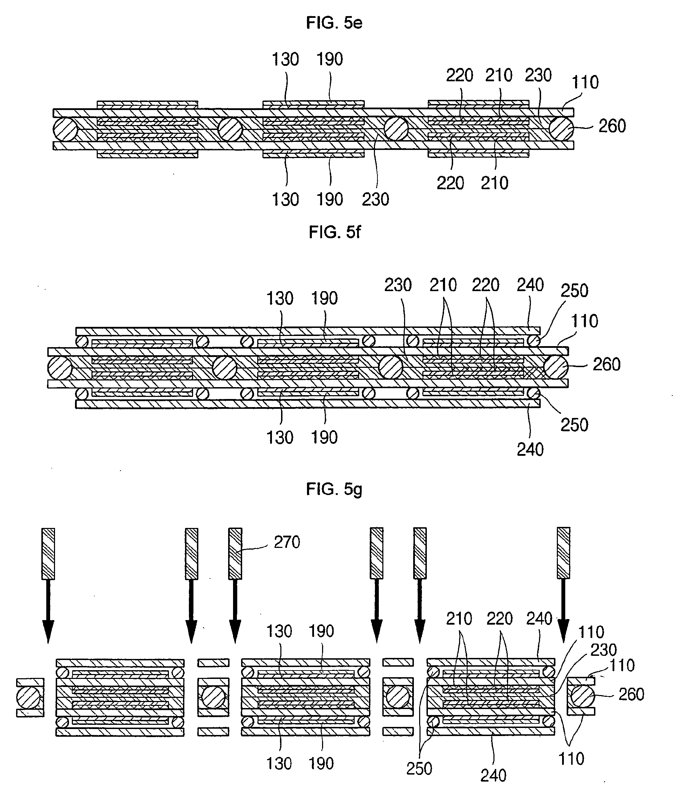

As shown in FIG. 5e, in the step S5 of forming the organic light emitting diode, organic light emitting diodes 190 are formed on the top surfaces of the respective semiconductor layers 130. More specifically, an anode, an organic thin layer and a cathode are sequentially formed on an insulating layer as described above. In one embodiment, after forming the organic light emitting diode 190, the pixel defining layer 200 is formed. Here, since the structure and forming method of the organic light emitting diode 190 have been described as above, the explanation about them will not be provided again.

The organic light emitting diodes 190 can be respectively formed on one substrate 110 and then on the other substrate 110. That is, one organic light emitting diode 190 can be formed on one substrate 110 and the other organic light emitting diode 190 can be formed on the other substrate 110 (or vise versa). Furthermore, the organic light emitting diodes 190 can be simultaneously (or concurrently) formed on the two substrates 110 if a process equipment permits.

As shown in FIG. 5f, in the step S6 of attaching the encapsulation substrate, encapsulation substrates 240 are attached by encapsulants 250 to the surfaces on which the semiconductor layers 130 and the organic light emitting diodes 190 are formed. Here, the encapsulation substrates 240 can be formed of any material selected from ordinary glass, plastic, polymer and their equivalents, but not limited thereto. In one embodiment, the area of the encapsulation substrate 240 is substantially smaller than that of the substrate 110. More specifically, the edges of the encapsulation substrate 240 (e.g., at least two opposite edges of the encapsulation substrate 240) can be shorter by 3cm to 8cm in an inward direction of that of the substrate 110, and thus the edge portion (or periphery) of the substrate 110 can be readily sawn in the following cutting (or sawing) process. Furthermore, the encapsulant 250 can be formed by at least one adhesive selected from an epoxy adhesive, a UV-ray setting adhesive, a frit and their equivalents, but not limited thereto. In addition, if a frit is used as the encapsulant 250, then it is necessary to heat the frit to a given temperature (which may be predetermined), and thus an encapsulation operation can be performed using a laser beam.

Furthermore, although an integrated encapsulation substrate 240 is shown in FIG. 5f, an encapsulation process can be performed by encapsulating each region on which each semiconductor layer 130 and organic light emitting diode 190 is formed by a respective encapsulation substrate 240. In such an embodiment, since each encapsulation substrate 240 should be attached by the respective encapsulants 250, the number of operation processes may be increased.

Also, the bottom surface of the encapsulation substrate 240 can be further provided with the transparent moisture absorption layer. That is, since the organic light emitting diode 190 is vulnerable to moisture, the transparent moisture absorption layer, which does not block the transmission of the light and can absorb moisture, can be formed on the bottom surface of the encapsulation substrate 240. In one embodiment, the transparent moisture absorption layer can become (or grow) thicker as long as the transparency of the encapsulation substrate 240 is ensured, and, in one embodiment, the thickness of the transparent moisture absorption layer is from 0.1µm to 300µm. In one embodiment, if the thickness of the transparent moisture absorption layer is below 0.1 µm, then the transparent moisture absorption layer does not have a sufficient moisture absorption characteristic. In another embodiment, if the thickness of the transparent moisture absorption layer is above 300µm, then the transparent moisture absorption layer can be in a danger of contacting the organic light emitting diode 190. Moreover, the transparent moisture absorption layer can be formed of at least one material selected from, but not limited thereto, an alkali metal oxide, an alkaline-earth metal oxide, a metal halide, a metal sulfate and a metal perchlorate, a phosphorus pentoxide (P₂O₅) and their equivalents, and, in one embodiment, the average particle diameter of which is below 100 nm and, in one embodiment, is from 20nm to 100nm.

Furthermore, according to one embodiment of the present invention, it is possible to carry out an encapsulation process by filling a space between the substrate 110 and the encapsulation substrate 240 with at least one material selected from a layered inorganic substance, a polymer, a hardening agent and their equivalents instead of forming the transparent moisture absorption layer on the encapsulation substrate 240. In one embodiment, after filling the space with the material, a heat treatment process is performed to harden the material.

Furthermore, according to one embodiment of the present invention, a polarizer film can be attached to the surface of each encapsulation substrate 240 to block (or prevent) the light reflection phenomenon due to an external light.

As shown in FIG. 5g, in the step S7 of cutting (or sawing), the substrates 110 are sawn so as to separate into respective units of organic light emitting displays. That is, in the step of cutting, the substrates 110 and the encapsulation substrates 240 that are positioned on the outer periphery of the semiconductor layers 130 and the organic light emitting diodes 190 can be sawn together. As described above, in one embodiment, each encapsulation substrate 240 can be attached only to the region that corresponds to each semiconductor layer 130 and each organic light emitting diode 190, and each unit of the organic light emitting display can be obtained by cutting only the corresponding substrates 110.

Furthermore, due to the step of cutting, the bonding agent 260 bonding the substrates 110 to each other is removed. In one embodiment, during the cutting process, it is possible for the bonding agent 260 itself to be cut (or sawn), and a portion of the bonding agent 260 can remain on the cut (or sawn) substrate 110. Moreover, such a cutting operation can be performed by at least one mechanism selected from a diamond wheel, a laser beam and their equivalents, but not limited thereto. In FIG. 5g, one or more laser beam emitters 270 are shown.

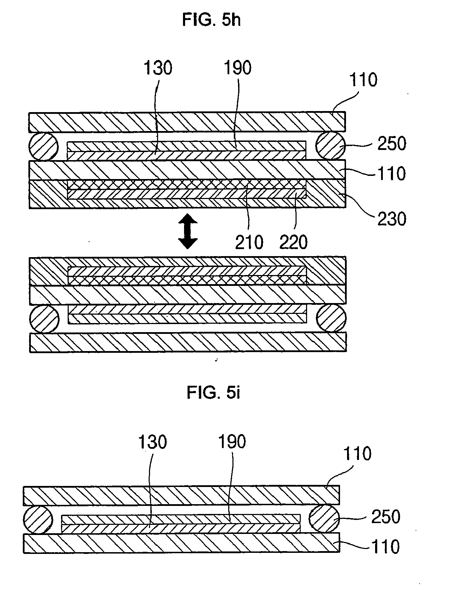

As shown in FIG. 5h, in the step S8 of separating the substrates, the two substrates 110 that have been sawn are separated from each other. In one embodiment, each of the separated substrates 110 is provided with the non-transmissive layer 210; the non-transmissive layer 210 and the magnetic layer 220; the non-transmissive layer 210, the magnetic layer 220 and the anti-friction layer 230; or the non-transmissive layer 210 and the anti-friction layer 230. Referring to FIG. 5h, the bottom surface of the substrate 110 is provided with the non-transmissive layer 210, the magnetic layer 220 and the anti-friction layer 230.

Here, if each anti-friction layer 230 is formed on each substrate 110 before the step of bonding the substrates, then the substrates can be readily separated from each other.

However, if the liquid anti-friction layer 230 is injected after bonding the substrates 110, then the substrates may not be readily separated from each other.
Hence, in this case, the anti-friction layer 230 is removed by a chemical solution that can dissolve the anti-friction layer 230. For this purpose, in one embodiment, the anti-friction layer 230 is formed of an organic material that can readily dissolve by a chemical solution.

According to an embodiment of the present invention, the step of separating the substrates 110 can be the last step. That is, after the step of separating the substrates 110, it is possible to deliver as a product by performing a cell test, a FPC (Flexible Printed Circuit) bonding, a module test and a reliability test. In one embodiment, the cell test can also be performed by separately forming a test region for the cell test before the cutting step.

Also, if the step of separating the substrates 110 is employed as the last step, the finished organic light emitting display (e.g., the organic light emitting display 101) can be provided with the non-transmissive layer 210; the non-transmissive layer 210 and the magnetic layer 220; the non-transmissive layer 210, the magnetic layer 220 and the anti-friction layer 230; or the non-transmissive layer 210 and the anti-friction layer 230.

As shown in FIG. 5i, in the step S9 of removing the non-transmissive layer, the non-transmissive layer 210 can be removed by an etching or grinding operation. More specifically, if only the non-transmissive layer 210 was formed on the bottom surface of the substrate 110, then the non-transmissive layer 210 is removed. Moreover, if the non-transmissive layer 210 and the magnetic layer 220 were formed on the bottom surface of the substrate 110, only the magnetic layer 220 can be removed, or the non-transmissive layer 210 and the magnetic layer 220 can be removed together. Furthermore, if the non-transmissive layer 210, the magnetic layer 220, and the anti-friction layer 230 were formed on the bottom surface of the substrate 110, only the anti-friction layer 230 can be removed, the anti-friction layer 230 and the magnetic layer 220 can be removed together, or the anti-friction layer 230, the magnetic layer 220 and the non-transmissive layer 210 can be removed together. In one embodiment, if the non-transmissive layer 210 and the anti-friction layer 230 were formed on the bottom surface of the substrate 110, only the anti-friction layer 230 can be removed, or the anti-friction layer 230 and the non-transmissive layer 210 can be removed together.

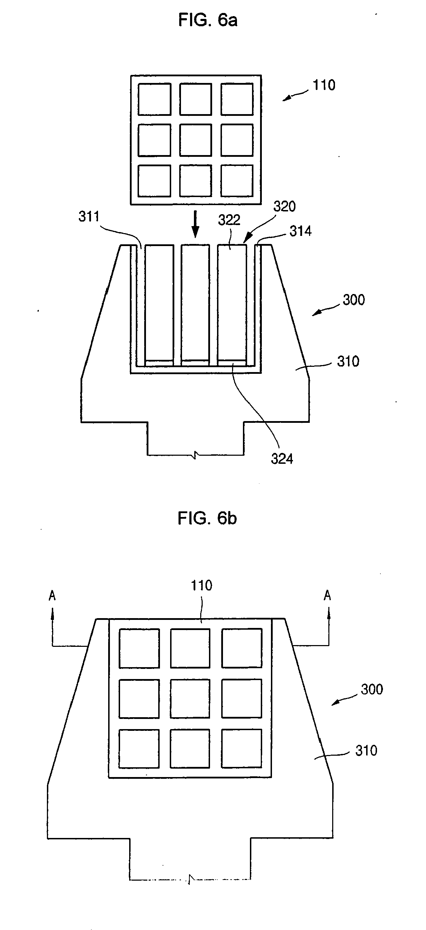

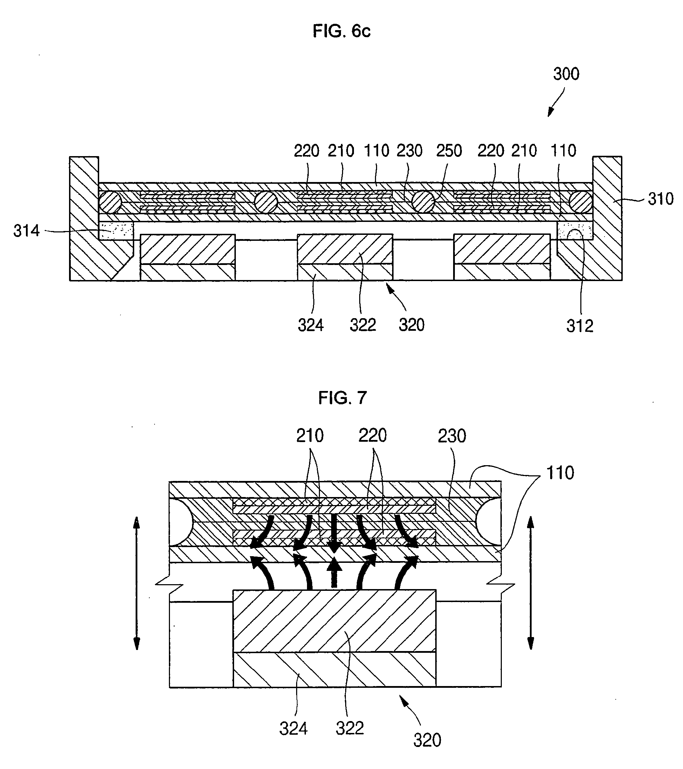

FIGs. 6a and 6b are top views of a moving device for an organic light emitting display according to an embodiment of the present invention, and FIG. 6c is a sectional view taken along the line A-A of FIG. 6b.

As shown in FIGs. 6a and 6b, a moving device 300 for an organic light emitting display includes a moving body 310 and a shock-absorbing member 320.

Referring now also to FIG. 6c, an opening 311 is formed on one side of the moving body 310 (although more than one opening may be provided), and a step 312 having a depth (which may be predetermined) is formed along the circumference of the opening 311 so as to receive the two bonded substrates 110. Moreover, an anti-slide pad 314 can be further formed on the step 312 so as to receive the bonded substrates 110 and to prevent (or hinder) the substrates 110 from sliding during the transfer thereof. The anti-slide pad 314 can be formed of any material selected from ordinary rubber, silicon and their equivalents, but not limited thereto.

Furthermore, the shock-absorbing member 320 extends from the step 312 of the moving body 310 by a length (which may be predetermined) so as to block (or prevent) the bonded substrates 110 from warping in the lower direction (i.e. downwardly) due to the weight of the substrates 110. A magnet 322 can be further attached to the region of the shock-absorbing member 320 that faces the bonded substrates 110. Hence, if the magnetic layer 220 is formed on the bonded substrates 110, then it repulses the magnet 322 of the shock-absorbing member 320. For this purpose, the magnetic layer 220 formed on the bonded substrates 110 and the magnet 322 mounted on the shock-absorbing member 320 should have the same polarity. Moreover, the magnet 322 formed on the shock-absorbing member 320 may be a permanent magnet or an electromagnet, but not limited thereto.

In addition, one or more elastic parts 324 can be provided on the boundary between the shock-absorbing member 320 and the moving body 310 so that the shock-absorbing member 320 itself can be moved (e.g., upwardly and downwardly moved) by a distance (which may be predetermined). That is, when the moving device 300 performs a transfer operation, the moving device 300 can vibrate due to an external force or a vibration of the moving device itself. Hence, the substrate 110 received in the moving device 300 also vibrates. Here, since the magnet 322 of the shock-absorbing member 320 repulses the magnetic layer 220 of the substrate 110, the shock-absorbing member 320 can also be moved (e.g., upwardly and downwardly moved) by a distance (which may be predetermined) due to the elastic part 324. For this purpose, the elastic part 324 can be formed by at least one mechanism selected from a spring, an air cylinder, a shock-absorbing pad and their equivalents that are formed on the coupling region with the moving body 310, but not limited thereto.

FIG. 7 shows a state in which a substrate is supported by a shock-absorbing member in a moving device according to an embodiment of the present invention.

As shown in FIG. 7, the magnetic layers 220 are formed on the surfaces of the substrates 110 that face each other. Moreover, the shock-absorbing member 320 with the magnet 322 attached thereto is positioned in the lower region that corresponds to the magnetic layers. Hence, if the vibration does not occur, then the magnetic layer 220 of the substrate 110 repulses the magnet 322 of the shock-absorbing member 320, and thus the shock-absorbing member 320 blocks or prevents the center of the substrate 110 from warping (e.g., warping downwardly in a non-contact manner).

Also, if a vibration is occurring during a transfer operation, then the substrate 110 vibrates, and thus the shock-absorbing member 320 also vibrates (e.g., upwardly and downwardly vibrates). That is, the shock-absorbing member 320 is also moved in the vibration direction of the substrate 110 by the elastic part 324 formed on the shock-absorbing member 320 and so the separation distance between the substrate 110 and the shock-absorbing member 320 is substantially maintained. Hence, the shock-absorbing member 320 is not brought into contact with the surface of the substrate 110, and thus the damage of the substrate 110 is blocked (or prevented).

An organic light emitting display according to an embodiment of the present invention can be readily applied to various electronic display devices, such as a cellular phone, a PDA, a notebook, a computer monitor and a television that are thin (or slim), by forming the organic light emitting display on a substrate having a thickness of from 0.05mm to 1mm.

Moreover, in one embodiment, the organic light emitting display can block (or prevent) a UV-ray from affecting a semiconductor layer and/or an organic light emitting diode through the substrate during use by forming a non-transmissive layer on the substrate.

A fabricating method of an organic light emitting display according to an embodiment of the present invention can reduce an entire processing time by about 50% by bonding two substrates having (or each having) the thickness of from 0.05mm to 1mm and performing simultaneously (or concurrently) a semiconductor forming process and an organic thin layer forming process (in one embodiment, each process includes a cleaning operation, an etching operation, a light exposure operation, a development operation, a heat treatment operation and so on).

Moreover, the fabricating method can block (or prevent) a UV-ray due to a light exposure operation during a fabricating process from affecting another opposing organic light emitting display by forming the non-transmissive layer on the bottom surface of the substrate.

Furthermore, the fabricating method can block (or prevent) the organic light emitting display from warping or being damaged due to gravity by a repulsive force between a magnetic layer and a moving device moving the substrate during a fabricating process by forming a non-transmissive layer and a magnetic layer on the bottom surface of the substrate.

In addition, the fabricating method can block (or prevent) the substrates or the metals formed on the surfaces of the substrates from contacting with each other when bonding the two substrates and thus can block (or prevent) the damage of the substrate by forming the non-transmissive layer, the magnetic layer and the anti-friction layer or the non-transmissive layer and the anti-friction layer on the bottom surface of the substrate.

A moving device of the organic light emitting display according to an embodiment of the present invention can block or prevent the substrate from warping or being damaged, by supporting the edge portion of the substrate on which a semiconductor layer and/or an organic light emitting diode are not formed by an anti-slide pad having a relatively high elasticity, and by supporting the central region of the substrate on which the semiconductor layer and/or the organic light emitting diode are formed by a shock-absorbing member in a non-contact manner.

Moreover, the moving device can block or prevent the central region of the substrate, which is not supported by the anti-slide pad, from contacting with the shock-absorbing member and can maintain the flat state of the central region of the substrate during transfer or process, by mounting a magnet on the shock-absorbing member so as to repulse the magnetic layer formed on the two bonded substrates.

While the invention has been described in connection with certain exemplary embodiments, it will be appreciated by those skilled in the art that the invention is not limited to the disclosed embodiments, but, on the contrary, is intended to cover various modifications included within the principles of the invention, the scope of which is defined in the claims and their equivalents.

## Claims

1. An organic light emitting display comprising:
a substrate having a first surface and a second surface;
an organic light emitting diode, an insulating layer and a semiconductor layer disposed on the first surface of the substrate, the insulating layer being disposed between the organic light emitting diode and the semiconductor layer; and
a non-transmissive layer disposed over the second surface of the substrate, wherein the non-transmissive layer is adapted to block UV-rays.

2. An organic light emitting display according to claim 1, further comprising:
a buffer layer disposed over the first surface of the substrate, the semiconductor layer being disposed over the buffer layer;
a gate insulating layer disposed over the semiconductor layer;
a gate electrode disposed over the gate insulating layer;
an inter-layer dielectric layer disposed over the gate electrode; and
a source/drain electrode disposed over the inter-layer dielectric layer, the insulating layer being disposed over the source/drain electrode and the organic light emitting diode being disposed over the insulating layer.

3. An organic light emitting display according to either preceding claim, wherein the substrate has a thickness ranging from about 0.05mm to about 1mm.

4. An organic light emitting display according to any preceding claim, wherein the substrate comprises a material selected from the group consisting of glass, plastic, polymer, steel, and combinations thereof.

5. An organic light emitting display according to any preceding claim, wherein the non-transmissive layer has a thickness ranging from about 0.05 µm and 0.3 µm.

6. An organic light emitting display according to any preceding claim, wherein the non-transmissive layer comprises a material selected from the group consisting of a metal that does not transmit UV-rays, a transparent UV-ray protective agent, an opaque UV-ray protective agent, and combinations thereof.

7. An organic light emitting display according to any preceding claim, wherein the non-transmissive layer comprises a material selected from the group consisting of chrome (Cr), chrome oxide (Cr₂O₃), aluminum (Al), gold (Au), silver (Ag), magnesium oxide (MgO), silver alloy, and combinations thereof.

8. An organic light emitting display according to any preceding claim, further comprising a magnetic layer disposed on a bottom surface of the non-transmissive layer.

9. An organic light emitting display according to claim 8, wherein the magnetic layer has a thickness ranging from about 10µm to about 100µm.

10. An organic light emitting display according to any of claims 8 to 9, wherein an anti-friction layer is further formed on a bottom surface of the magnetic layer.

11. An organic light emitting display according to any of claims 1 to 7, further comprising an anti-friction layer disposed on a bottom surface of the non-transmissive layer.

12. An organic light emitting display according to claim 11, wherein the anti-friction layer has a thickness ranging from about 10µm to about 100µm.

13. An organic light emitting display according to any of claims 11 to 12, wherein the anti-friction layer comprises a material selected from the group consisting of an organic material and an inorganic material.

14. An organic light emitting display according to any preceding claim, further comprising an encapsulant disposed on a periphery of the first surface of the substrate, and an encapsulation substrate attached to the encapsulant.

15. An organic light emitting display according to claim 1, further comprising:
a buffer layer disposed over the first surface of the substrate, the gate electrode being disposed over the buffer layer;
a gate insulating layer disposed over the gate electrode;
a semiconductor layer disposed over the gate insulating layer;
an inter-layer dielectric layer disposed over the semiconductor layer; and
a source/drain electrode disposed over the inter-layer dielectric layer, the insulating layer being disposed over the source/drain electrode and the organic light emitting diode being disposed over the insulating layer.

16. A fabricating method of an organic light emitting display, the method comprising:
providing a first substrate and a second substrate;
forming a first non-transmissive layer on a bottom surface of the first substrate;
forming a second non-transmissive layer on a bottom surface of the second substrate;
bonding the first substrate to the second substrate so that the first and second non-transmissive layers face each other;
forming a first semiconductor layer over a top surface of the first bonded substrate;
forming a second semiconductor layer over a top surface of the second bonded substrate;
forming a first organic light emitting diode over the first semiconductor layer;
forming a second organic light emitting diode over the second semiconductor layer;
attaching an encapsulation substrate by an encapsulant to the top surface of each of the first and second substrates;
cutting a portion of the first and second substrates on which the first and second semiconductor layers and the first and second organic light emitting diodes are not formed; and
separating the first and second bonded substrates into a first fabricated substrate and a second fabricated substrate.

17. A fabricating method according to claim 16, wherein at least one of the first non-transmissive layer or the second non-transmissive layer is formed to have a thickness ranging from about 0.05 µm to about 0.3 µm.

18. A fabricating method according to claim 16 or 17, wherein at least one of the first non-transmissive layer or the second non-transmissive layer is formed by coating a UV-ray protective agent.

19. A fabricating method according to any of claims 16 to 18, wherein at least one of the first non-transmissive layer or the second non-transmissive layer is formed by forming a material selected from the group consisting of a metal that does not transmit the UV-ray, a transparent UV-ray protective agent, an opaque UV-ray protective agent, and combinations thereof.

20. A fabricating method according to any of claims 16 to 19, wherein at least one of the first non-transmissive layer or the second non-transmissive layer is formed by forming a material selected from the group consisting of chrome (Cr), chrome oxide (Cr₂O₃), aluminum (Al), gold (Au), silver (Ag), magnesium oxide (MgO), silver alloy, and combinations thereof.

21. A fabricating method according to any of claims 16 to 20, further comprising forming a magnetic layer on a bottom surface of at least one of the first non-transmissive layer or the second non-transmissive layer.

22. A fabricating method according to claim 21, further comprising forming an anti-friction layer on a bottom surface of the magnetic layer.

23. A fabricating method according to any of claims 16 to 20, further comprising forming an anti-friction layer on the bottom surface of at least one of the first non-transmissive layer or the second non-transmissive layer.

24. A fabricating method according to any of claims 16 to 23, wherein the encapsulation substrate has an area smaller than that of at least one of the first substrate or the second substrate.

25. A fabricating method according to any of claims 16 to 24, wherein the cutting is performed by cutting at least one of the first substrate or the second substrate and the encapsulation substrate at a position corresponding to an outer periphery of at least one of the first semiconductor layer or the second semiconductor layer and at least one of the first organic light emitting diode or the second organic light emitting diode.

26. A moving device for an organic light emitting display comprising:
a moving body having an opening formed on one side thereof, in which a step having a depth is disposed on a circumference of the opening so as to receive a substrate during the fabrication of organic light emitting displays according to any of claims 1 to 15; and
at least one shock-absorbing member extending from the step of the moving body by a distance and configured to absorb a shock and/or to prevent the substrate from warping.

27. A moving device according to claim 26, further comprising an anti-slide pad disposed on the step of the moving body and configured to receive the substrate and to prevent the substrate from sliding.

28. A moving device according to claim 26 or 27, further comprising a magnet attached to a region of the shock-absorbing member facing the substrate.

29. A moving device according to any of claims 26 to 28, further comprising an elastic part disposed on a coupling region of the shock-absorbing member with the moving body.
